# EUROPEAN PATENT APPLICATION

(11) **EP 1 221 722 A1**
(43) Date of publication of application: **10.07.2002**
(21) Application number: 01200018.8
(22) Date of filing: 06.01.2001
(51) Int. Cl.: H01L 33/00, H01L 27/15

(54) **Highly efficient paraboloid light emitting diode**

(71) Applicant: INTERUNIVERSITAIR MICROELEKTRONICA CENTRUM VZW, 3001 Leuven (BE); VRIJE UNIVERSITEIT BRUSSEL, 1050 Brussel (BE)
(72) Inventor: Heremans, Paul, 3000 Leuven (BE); Kuijk, Maarten, 2600 Antwerpen (BE)
(74) Representative: Bird, William Edward

(57) **Abstract**

The present invention discloses a highly efficient light emitting diode with directional properties comprising a light cavity of semiconductor material. A portion of the surface of the light cavity acts as a parabolic shaped reflector. A light generation zone is located substantially at the focal point of this paraboloid reflector. The light out-coupling interface of the cavity is close to the focal point allowing both downward and upward generated photons to escape from the semiconductor cavity. Photons reach the out-coupling interface in perpendicular way within the out-coupling cone of the semiconductor-surrounding medium interface.

## Description

### Field of the invention

The present invention relates to a light emitting opto-electronic component comprising a semiconductor body and methods of making the same.

### Background of the invention

A need exists for highly efficient Light Emitting Diodes (LED's) for applications in data communication as well as for illumination purposes A Light Emitting Diode normally comprises a semiconductor part wherein the light is generated, means to supply current to this semiconductor part and a medium surrounding the semiconductor part. The external efficiency of such LED depends not only on the amount of light generated within the semiconductor part of the device, but also on the amount of this generated light that is being emitted by the device to its surroundings. The medium surrounding the semiconductor part can be, for instance, air or an optical transparent polymer embedding this semiconductor part. Most often only a small part of the photons generated in the semiconductor part will find their way to the medium surrounding the semiconductor part. Because the refractive index of the semiconductor part is larger than the refractive index of the surrounding medium, only the fraction of photons that is being emitted in a direction substantially perpendicular to the interface between the semiconductor part and the surrounding medium can escape. An incident angle can be defined as the angle between the direction of the incident light and the normal to the interface between the out-coupling interface, i.e. the interface between the semiconductor part and the surrounding medium. All photons having an incident angle larger than a critical value, will be total internally reflected and might finally be absorbed within the semiconductor material. The larger the difference in refractive index between the semiconductor material and its surroundings, the smaller this critical incident angle will be. As the index increases, less photons can escape from or are being coupled out from the semiconductor part to the surrounding medium and the external efficiency of the device will be less.

Two ways to improve the photon escape probability are known in the state of the art.

The first one is to make a resonant cavity in which the generation of photons with a k-vector substantially perpendicular to the out-coupling interface is promoted. Such a device is disclosed in patent EP0550963 "An improved light emitting diode". These photons are very likely to escape from the semiconductor surface, since they fall within the out-coupling escape cone as being defined by the critical incident angle. A collimated beam of light is generated. Unfortunately, due to the resonance, output efficiency and directionality depend quite strongly on the temperature, limiting the usefulness of this type of LED to some niche applications and markets.

A second way to increase the external efficiency is to have some photons reflected a multiple number of times at the semiconductor-surrounding medium interface. At each reflection the incident angle changes until the incidence angle falls within the out-coupling escape cone and hence the photon can sometimes be emitted from the interface. These LED's with multiple internal reflection don't provide a directed light output or a parallel beam. Furthermore, each time a photon is internally reflected, the semiconductor material might absorb this reflected photon. Hence, the external efficiency of such an LED will still be sub-optimal.

A first example is a non-resonant cavity device, as disclosed in EP-A-0977280 "Devices for emitting radiation with a high efficiency and a method for fabricating such devices". The photons reflect between a backside mirror and a roughened out-coupling interface. Thanks to this roughening the orientation of the out-coupling interface is likely to differ at each incidence of the photon. A second example is a device comprising a waveguide and a tapered lateral decoupling zone, as disclosed in EP-A-0996984 "Beam emitting opto-electronic component". In this device the photons are generated in a radiating zone and then transported by a planar optical waveguide to the bevel of the semiconductor part of the device. The bevel of the semiconductor part is tapered thereby providing an incident photon with several escape directions. To achieve a good efficiency, however, the diameter of this LED has to be quite large in order to assure that the photons reach the tapered decoupling zone with the required incident direction so that at incidence the photon is reflected within the escape cone of the semiconductor part-surrounding medium interface.

### Aim of the invention

It is an object of the present invention to provide an opto-electronic device with improved light output efficiency.

It is a further object of the present invention to provide a single out-coupling interface or radiating surface for an opto-electronic device and hence, to improve light output efficiency.

Yet a further object of the present invention is to provide methods for fabricating multiple opto-electronic components on the same substrate, preferably in a monolithic way.

A further object of the present invention is to enhance the directionality of the emitted light from an opto-electronic component.

### Summary of the invention

In one aspect of the present invention a light emitting device is provided, comprising a body of semiconductor material (15) having a radiation generating zone (10) and least one reflecting surface (11) and at least one radiating surface (13), characterized in that, said reflecting surface (11) is oriented to said radiating surface (13) such that radiation emitted by said radiation generating zone (10) is redirected by said reflecting surface (11) to pass through said radiating surface (13) substantially perpendicular to said radiating surface (13). Such a device can have a substantially planar or curved radiating surface (13) and a substantially planar or curved reflecting surface (11). Either the radiating surface or the reflecting surface can have, for example, a spherical or conic of revolution form or its Fresnel-equivalent. For example, the reflecting surface may be shaped as a paraboloid of revolution or its Fresnel-equivalent For instance, such a device can have a semi-spherical radiating surface (13) and a substantially planar reflecting surface (11). In some embodiments, the radiation generating zone (10) is positioned substantially at the focal point of said reflecting surface (11). Preferably a major portion of the light from the radiation generating zone which is reflected from the reflecting surface should be re-directed such as to exit through the radiating surface of the semiconductor body (that is preferably greater than 50%, more preferably greater than 70%, most preferably at least 90%).

The light generation region (10) should preferably be kept small in size. Preferably it is located at the focal point of a curved reflecting surface (11). This focal point is preferably located adjacent to the radiating surface (13). The radiation generating zone (10) is preferably confined in directions perpendicular and parallel to the radiating surface (13) by current-confinement techniques: several means are disclosed to confine the region where electrical carriers of the opposite type meet and recombine. These means include, for instance, the use of poor conductivity of a layer, the use of lateral oxidation of a layer, and the use of proton or ion implantation.

The body of the device (15) may be made of a single semiconductor material. The body of the device (15) can also be made of more than one material, preferably semiconductor materials, having a substantially similar optical refractive index.

Methods of manufacturing a light emitting device, according to an aspect of the present invention are disclosed, for example a device comprising a body of semiconductor material having a radiation generating zone (10), a radiating surface (13) and a reflecting surface (11. The method may comprise the steps of shaping the surface of said body in a reflecting and a radiating portion, said reflecting portion being oriented to said radiating portion such that a substantial part of the radiation emitted by said radiation generating zone is redirected at first incidence on said reflecting portion to pass through said radiating portion, substantially perpendicular to said radiating portion.

A device for emitting a collimated beam of light is also disclosed comprising a radiation generating zone (10) embedded or formed in a body of semiconductor material (15). This body has optical properties, e.g. refractive index, substantially similar to these of the radiation generating zone (10). The surface of the body (15) is shaped in a reflecting (11) and a radiating portion (13). The reflecting portion (11) is oriented to the radiating portion (13) such that radiation emitted by the radiation generating zone (10) is redirected at first incidence on the reflecting portion (11) of the surface to pass through the radiating portion (13) of the surface, substantially perpendicular to this radiating portion (13). The light is preferably re-directed to bypass the semiconductor material body.

The present invention may also provide a device for emitting a collimated beam of light, comprising a radiation generating zone (10) formed in a body of semiconductor material (15), a reflecting (11) and a radiating surface (13), said reflecting surface (11) being oriented to said radiating surface (13) such that radiation emitted by the radiation generating zone (10) is redirected by said reflecting surface (11) to pass through said radiating surface (13) substantially perpendicular to said radiating surface (13) characterized in that said reflecting (11) and said radiating (13) surfaces are surfaces of said body of semiconductor material (15). Preferably the surface of said body of semiconductor material (15) consists of said reflecting (11) and said radiating surface (13). The radiating generating zone is preferably located substantially at the focal point of the reflecting surface (11), when the reflecting surface is curved, e.g. spherically or with the form of a conic of revolution.

The present invention may also provide a light emitting device comprising a body of semiconductor material (15). The body (15) has a radiation generating zone (10), a reflecting (11) and a radiating (13) surface, characterized in that said reflecting surface (11) has a spherical form or the form of a conic of revolution, e.g. parabolic, said radiating surface (13) is substantially planar and said radiation generating zone (10) comprises at least one quantum well. The radiation generating zone may be located substantially in the focal point of said substantially parabolic shaped reflecting surface (11). The device may also include a first (40) and a second contact (51) contacting opposite sides of said radiation generating zone (10).

The present invention may provide devices with improved light emitting efficiencies, e.g. by reducing the number of internal reflections or by creating a collimated light beam or a substantial parallel beam of light.

The present invention will now be described with reference to the following drawings.

### Brief description of the drawings

**Figs. 1 to c** are schematic drawings of a preferred embodiment of the present invention. Fig. 1(a) shows a light generating region (10) and a reflector (11); Fig. 1(b) illustrates a modification to the device of Fig. 1(a) showing a focusing or convergence of the emitted light; Fig. 1(c) shows a similar device but with a degree of defocusing or divergence of the emitted beam. The modifications of Figs. 1 (b) and (c) may be achieved as a function of the relative position of the light generation region (10) with respect to the focal point of the reflecting surface (11).
**Fig. 2** is schematic drawing of an alternative embodiment of the present invention having a paraboloid reflector (11) whereby the paraboloid reflector is of the Fresnel-reflector type.
**Fig. 3** is a schematic drawing of an embodiment of the present invention whereby the radiating surface (13) is semi-spherical and the reflecting surface (11) is substantially planar.
**Fig. 4** depicts an embodiment of the present invention for confining the light generation region (10), by (a) using the poor conductivity of a layer (47) or (b) by lateral oxidation (52).
**Fig. 5** depicts an embodiment of the present invention using proton or ion implantation for confining the light generation region (10).
**Fig. 6** is a schematic representation of a process sequence according to an embodiment of the present invention
**Fig. 7** is a schematic representation of a process sequence according to an embodiment of the present invention
**Fig. 8** is a schematic representation of a process sequence according to an embodiment of the present invention

### Detailed description of several embodiments of the present invention

The invention is described in the following by a detailed description of several embodiments of the invention. It is obvious that other embodiments of the invention can be configured according to the knowledge of persons skilled in the art without departing from the true spirit of the invention, the invention being limited only by the terms of the appended claims. Exemplary embodiments of the invention and of the use of the invention are shown in the drawings. The drawings are schematic, non-limiting representations of the invention and therefore the dimensions and the relative dimensions do not correspond to actual reductions to practice of the invention.

In a first aspect of the present invention the general operation principles of the invention are outlined.

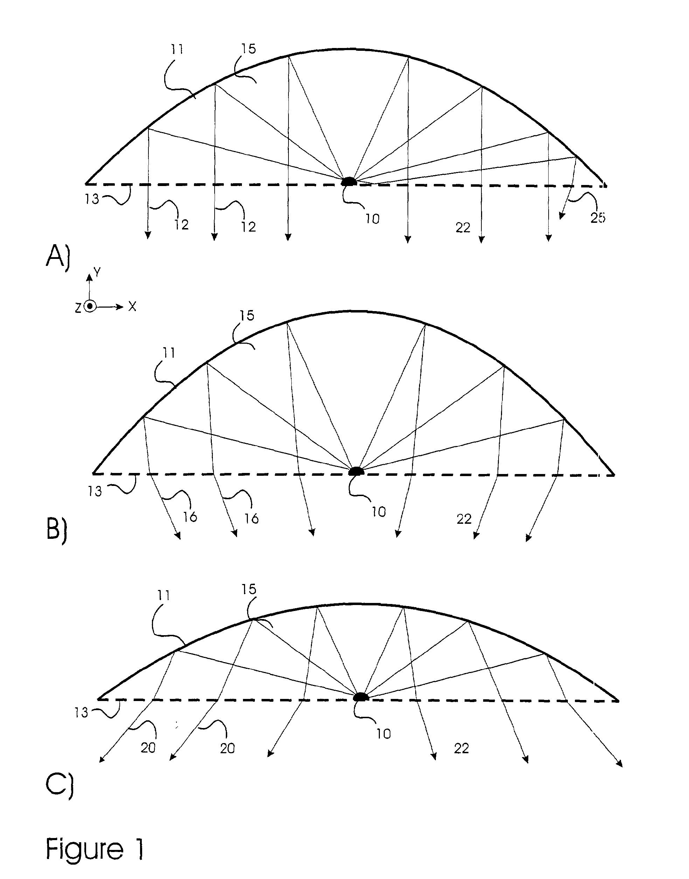

Figs. 1A to C are schematic views of an opto-electronic device according to a first embodiment of the present invention. The opto-electronic device may be an LED comprising a body of material (15), preferably of semiconductor material, having a radiation generating zone (10). Light or electromagnetic radiation generated in this radiation generating zone (10) will be emitted in all directions as illustrated in Fig. 1A by the arrows (12). For the purposes of simplification of this description only this radiation generating zone (10) can be considered as a single point from which light is emitted. The generation of light should preferably be confined or limited in space to avoid production of light outside the immediate vicinity of the focal point of a reflector surface (11). A portion of the surface of the semiconductor material (15) has a spherical shape or is shaped as a conic of revolution, e.g. a paraboloid, a hyperboloid. This portion of the surface is preferably a paraboloid. This portion of the surface will be labeled as the reflection surface (11) or reflector. Another portion (13) of the surface of the semiconductor body (15) is used to out-couple, that is to radiate or to emit light generated in the radiation generating zone (10). This surface is preferably planar. A part of the generated light will reach this radiating surface (13) directly from the radiation generating zone (10). This light is labeled as being emitted to the front of the body or to the lower hemisphere. Light can also reach the radiating surface indirectly after being reflected on the reflection surface (11). This light is labeled as being emitted to the back of the body or to the upper hemisphere. The position of the radiation generating zone (10) thus defines an upper and a lower hemisphere. The semiconductor body is surrounded by a surrounding medium (22). Typical surrounding media (22) include air, glass, plastic, a fiber optic faceplate or semiconductor material. The surrounding medium may have optical properties, e.g. an optical refractive index, substantially different from the optical properties of the semiconductor body (15). Between the light radiation zone (10) and the reflection surface (11) only material, preferably semiconductor material, with substantially similar optical properties, e.g. an optical refractive index, is present. The difference in refractive index is preferably 30% or less, more preferably 20% or less. If the semiconductor body (15) is made of a single semiconductor material, this requirement can be met. If the semiconductor body (15) comprises different layers, e.g. semiconductor or dielectric layers, these layers should preferably have a substantially similar optical refractive index. Internal reflection of the emitted light is therefore more likely to occur at the surface of the body (15) or at the interface between the body (15) and the surrounding medium (22) than within the body (15). Preferably the materials of the body (15) do not substantially absorb the radiation generated in the light generation zone (10) as this would lead to a decrease in the external efficiency of the device. An example of such a stack of materials is a body (15) composed of AlGaAs, having an Al content of 20%, which will not absorb the light generated in a light generation zone (10) made of GaAs.

If the radiation generation zone (10) is positioned substantially in the focal point of the reflecting surface (11), photons (12) emitted towards the back of the body will reflect on the parabolic shaped reflector (11). The reflected photons will move essentially parallel to the main optical axis of the parabolic shaped reflector. In the example given in Fig. 1 the photons will travel along the arrows (12) and after reflection move along the Y-axis in downward direction. The out-coupling surface (13) is oriented substantially perpendicular to the direction of incidence of the reflected photons. The reflected photons will reach the out-coupling surface (13) within the escape cone of this surface and can be emitted from this surface in a substantially collimated beam of radiation.

When the light generation zone (10) is displaced away from the focus, as illustrated in Fig. 1B, such displacement will result in emitted rays (16) having a focusing or convergent behavior. When the light generation zone (10) is displaced towards the reflector (13), as illustrated in Fig. 1C, such displacement will result in emitted rays (20) having a de-focusing or divergent behavior. The extent to which the out-coupled beam can have a focussing or defocusing behavior depends on the relative position of the generation zone (10) and the focal point of the reflector (11) and on the relative difference in refractive index between the semiconductor body (15) and the surrounding medium (22). The latter difference determines the escape cone and hence the maximum angle at which an incident photon will be emitted from the interface (13), and consequently the maximum focus or defocus of a beam. By positioning the light generation region nearer to or away from the reflector, the light output will be defocused or focused respectively, and can be adjusted to serve the wish of the optical designer.

The out-coupling surface (13) should preferably be positioned as close as possible to the light generation zone (10), such that essentially all the photons initially emitted downwards in the drawings are reflected very close to the light generation zone in an upward direction. If the radiation generating zone (10) is positioned close to the out-coupling surface (13) photons initially directed towards the lower hemisphere, i.e. emitted towards the front of the semiconductor body (15) will reflect against the out-coupling interface (13). The angle at which these forwardly emitted photons will reach the out-coupling surface (13) is more likely to fall outside the escape cone of this surface (13). These forwardly emitted photons are reflected at this surface (13) towards the back (11) of the body (15) at which these photons will be reflected again. These photons will further move in a forward direction as originally directed (e.g. photon 25 in Fig. 1A). Only a few percent of the initially downwards-directed photons will escape from the out-coupling surface (13), at first incidence at this surface (13), due to a large difference in refractive index between the semiconductor body (15) and the surrounding medium (22). This small amount of forwardly emitted photons forms a small light output fraction that is Lambertian. Preferably the focal point of the reflecting surface (11) is located adjacent to the radiating surface (13) or in other words; the out-couple surface (13) should substantially coincide with the focal plane of the reflecting surface (11). Ideally the radiation surface (13) should coincide with the focal plane of the reflection surface (11).

The diameter of an LED according to the present invention, having the radiation generation zone (10) and the out-coupling interface (13) adjacent to the focus or to the focal plane of reflecting surface (11), may be about 4 times the height of this LED. Typical dimensions of such a device are a height of 5 micron with a diameter of 20 micron or a height of 50 micron and a corresponding diameter of 200 micron.

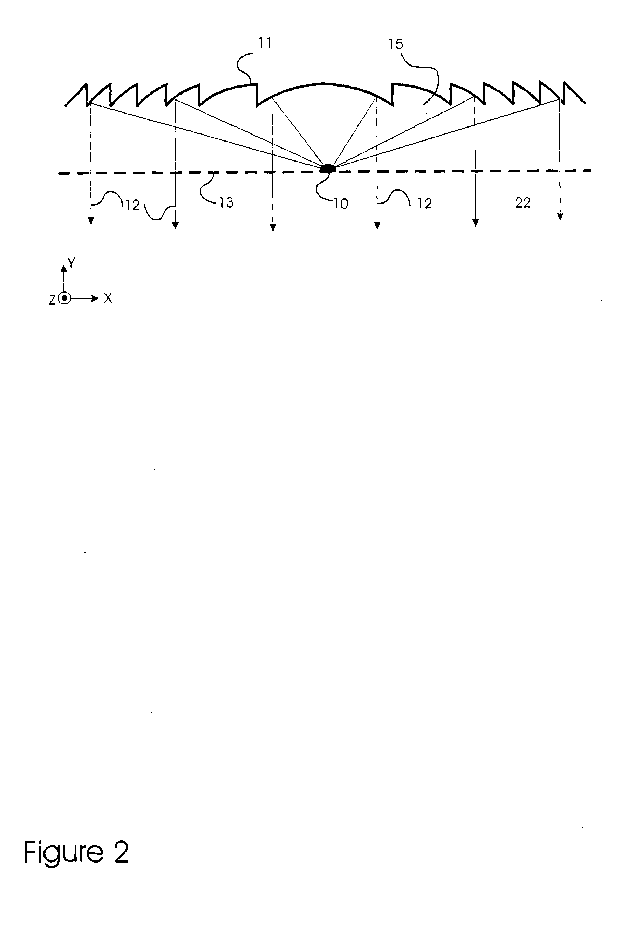

In a second embodiment an alternative to a parabolic shaped reflector (11) is given. Such an alternative can be a Fresnel type of reflector as shown in Fig. 2. It is known to a person skilled in the art that most lenses have a Fresnel equivalent. Similarly, reflectors can have a Fresnel equivalent. Gray-scale mask technology allows the manufacturing of such equivalent structures, as will be explained in further embodiments. Also in case of a Fresnel equivalent reflector the light generation is preferably confined to a region (10) located as much as possible at the focal point of the constructed equivalent reflector. The reflecting properties of the reflecting surface (11) can also be improved by depositing a dielectric and metallic layer, as will be illustrated in further embodiments. Rays (12) can be made focussing (convergent) or defocusing (divergent), according to the design specifications, by changing the relative position of the radiation generation zone (10) and the out-couple surface (13) as already illustrated in the foregoing embodiments (see Figs. 1B and 1C).

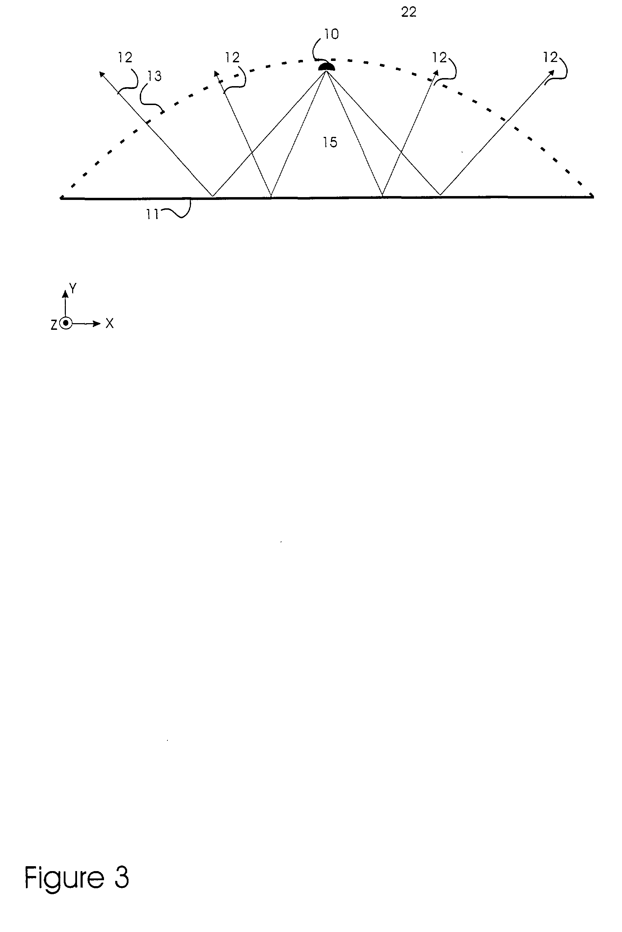

In a third embodiment another alternative to a semi-spherical, concave or parabolic shaped reflector (11) is provided. As illustrated in Fig. 3 the radiating surface (13) can be made semi-spherical or in the form of a conic of revolution and the reflecting surface (11) can be substantially planar. The light generation zone (10) is located adjacent to the out-couple surface (13) at a symmetry axis of the device.

In a second aspect of the present invention methods for manufacturing devices according the present invention are given.

In a fourth embodiment of the present invention, methods are presented to manufacture a semi-spherical, concave shaped reflector or one I the form of a conic of revolution, e.g. a parabolic form. Preferably a gray scale mask patterning process is applied. Such a process comprises the following steps: a gray scale mask is used to generate a photoresist layer with variable thickness on a semiconductor surface. Subsequently the shape of this photo-resist is transferred to the semiconductor substrate by anisotropic etching, e.g. dry etching. The difference in etching speed between photo-resist and semiconductor material should be taken into account in order to obtain the desired shape of the reflecting portion (11) of the semiconductor body. Such a gray scale patterning process offers enough precision to manufacture devices according to the present invention. An example of such a gray scale manufacturing process is described in US5480764 "Gray scale microfabrication for integrated optical devices".

A somewhat less precise, however cheaper, solution is to reflow cylindrical islands of photo-resist into lens like islands. These cylindrical islands are obtained by spinning photo-resist on a substrate, performing a lithographic step in which circles in the resist are defined. The density of circles will define the local amount of resist remaining after exposure and development. The substrate and the resist are heated, causing a reflow of the resist thereby forming a continuous lens-like shaped resist layer. Again the shape of the photo-resist islands is subsequently transferred to the semiconductor substrate by anistropic etching. The difference in etching speed between the photo-resist and the semiconductor material may favorably be exploited to construct a first order approximation of a parabolic shape in the semiconductor.

In a fifth embodiment of the present invention, improvements to the reflecting properties of the reflector (11) and of the out-couple surface (13) are described.

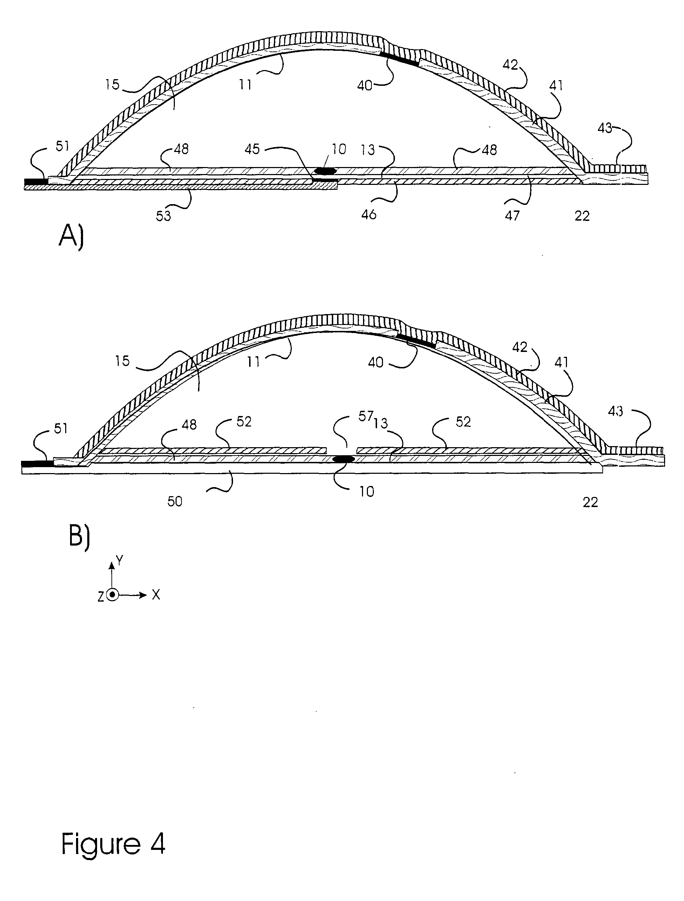

Fig. 4A shows a more detailed view of a reflector (11) according to the present invention. Besides the aforementioned parabolic shape of a portion of the semiconductor body, the reflecting properties of the reflector (11) can be improved by adding a dielectric layer (41), e.g. a deposition of SiO₂, on top of the semiconductor material. Optionally, a conductive layer, e.g. a metal layer (42), can then be deposited on top of this dielectric layer (41). A reflector constructed by a dielectric layer and a conductive layer provides a very good mirror. Most of the light is reflected by total internal reflection at the semiconductor (15) to dielectric (41) interface (11), and the remaining part of the incident light is reflected by the metal mirror (42).

To achieve very high external efficiencies, a dielectric layer (e.g. layer 46 in Fig. 4A) can be deposited on the out-coupling interface (13). This dielectric layer serves as an antireflective coating for the photons that are coupled out. The anti-reflection coating at the out-coupling interface (13) can minimize the residual Fresnel-reflection at this interface as known to a person skilled in the art. The thickness and choice of materials of this antireflective coating (46) depend on the difference in refractive index between the body (15) and the surrounding medium (22) for a given limited range of incidence angle.

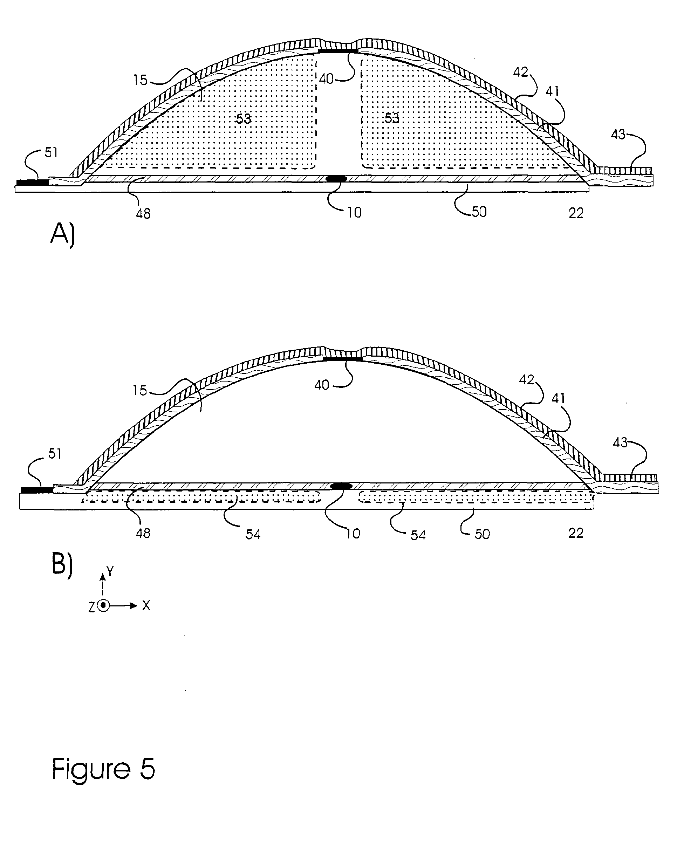

In a sixth embodiment of the present invention methods to confine the generation of radiation are described, as illustrated schematically in Figs. 4 and 5. As explained above, the radiation generating zone (10) should be positioned substantially at the focal point of the reflecting surface (11). The dimensions of the radiation generating zone (10) should preferably be as small as possible in order to confine the generation of light to this focal point and avoid the production of light outside the focal point. Most often this confinement in directions perpendicular and parallel to the radiating surface of the zone in which light is generated, is obtained by orienting or locally restricting the flow of electrical carriers. A limited zone is defined in which both types of electrical carriers can recombine and generate radiation.

Preferably, an ohmic contact (40) to the cavity or semiconductor body (15) is constructed to provide a path for a flow of a first type of electrical carriers throughout the bulk of the cavity (15) to the radiation generating zone (10) (see Fig. 4a) manufactured in active layer (48). Connection pad (43) is a current inlet for the LED, and the metal layer (42) of the reflecting mirror can serve as a current path to such an ohmic contact (40). If such a metal layer (42) is not present other ways of directing the current to the contact (40) known in the art can be used.

Layer (48) is the active layer formed in or on top of the semiconductor body (15) of e.g. a typical double hetero structure LED known in the art. Light is generated preferentially in a light generation zone (10) comprising a well, a quantum well, or multiple quantum wells (10) constructed in this active layer (48). Such an active layer (48) or set of active layers automatically limits the light generation in the Y-direction very efficiently to the dimensions of this layer or stack of layers. These dimensions are typically in the range of 1 to about 500 nanometer. A double hetero junction is an example of such a device structure. The light generated in zone (10) of the active layer (48) should essentially not be absorbed in the bulk of the body (15) and the layer (47).

Confinement of light generation in the X and Z directions can be achieved by adding a confinement layer (47) to the body (15), as illustrated in Fig. 4a. This confinement layer (47) should have a low conductivity such that the light generation occurs preferably close to the ohmic contact (45), situated underneath the radiation generating zone (10). The preferred solution here is to use a p-doped layer (47), and an n-doped bulk semiconductor. A p-doped layer is in most material systems automatically much less conductive, resulting in a current confinement in X and Z direction. A metal finger (53) formed on this confinement layer (47) can be used to direct the current to the ohmic contact (45) at which the carriers are injected in the p-doped layer (47). The area of this finger (53) is preferably small enough not to limit the emission of light by the out-coupling surface (13) too much by shadowing. This finger (53) should be electrically separated from the semiconductor body (15) or from the confinement layer (47) by a dielectric layer (46), e.g. polyimide. This dielectric layer can also serve the purpose of an anti-reflection coating for the emitted radiation, as mentioned above (see layer 46, Fig. 4A).

Another way of achieving X and Z direction confinement is illustrated in Fig. 4b. Patent US 5594751 "Current-apertured vertical cavity laser" discloses methods for current confinement. A layer (52) is oxidized laterally leaving an aperture (57) for the flow of a first type of carriers passing trough the bulk of the cavity (15). Semiconductor layer (50) allows the carriers of the opposite type coming from the contacting pad (51) to reach the light generation zone (10) and serves as an conductive path. This semiconductor layer essentially doesn't reflect or absorb the light generated in the active layer because this layer (50) will be transparent for the generated radiation. In this example illustrated in Fig. 4b, the oxidized layer (52) is located above the active layer (48). However, in some applications it can be considered to swap the relative positions of the dielectric and active layer.

Another way of achieving X and Z direction confinement is illustrated in Fig. 5, using proton or ion implantation to locally lower the conductivity in the semiconductor body (15). In one embodiment (Fig. 5a) the resistivity of region (58) in the bulk of the body (15) is increased to the desired level. In this case, contact (40) should preferably be centered on the parabolic reflector. The conductive path in between the high resistivity area's (53) in the bulk of the body (15) will conduct carriers throughout the body to the light generation region (10). Layer (50) will conduct carriers of the opposite type from the contacting pad (51) to the light generation region (10).

In a further embodiment (Fig. 5B) the recombination area of the device is limited in space by changing via proton or ion implantation the resistivity of a conductive layer (55), thereby defining high resistivity regions (54). These regions will isolate both conductive paths. Also here a layer (50) will conduct carriers of the opposite type from the contacting pad (51) to the light generation region (10).

It is believed that the active layer (48) should preferably not be made resistive by use of the proton or ion implantation. At lower currents an increased resistivity could lead to an increase in non-radiative recombination, and lower the possibility for radiative recombination, and therefore lower the internal efficiency.

In a seventh embodiment process sequences to manufacture devices according to the present invention are described.

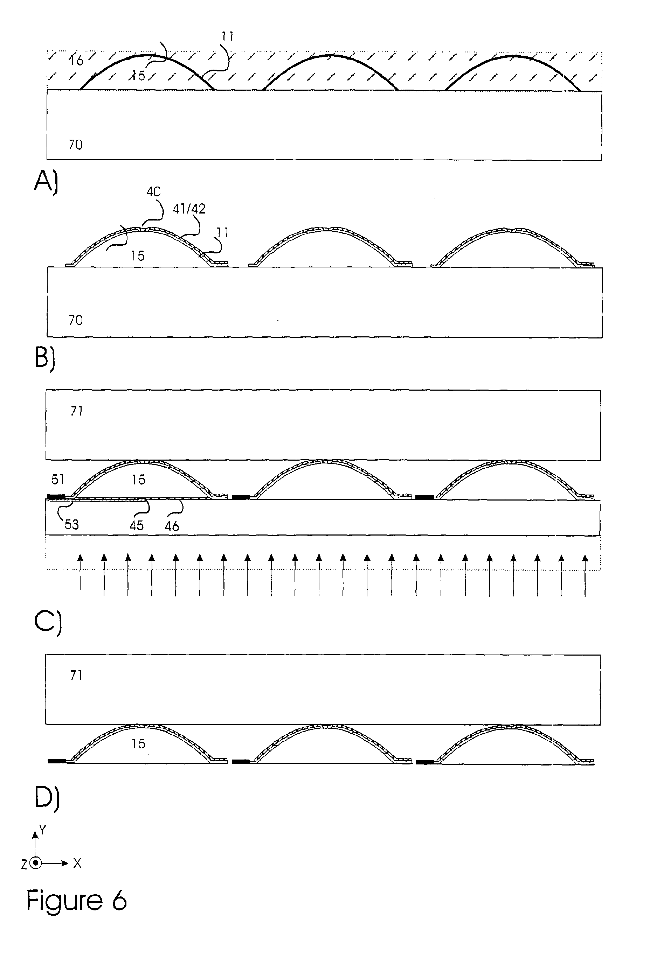

In a first process sequence, firstly (Fig. 6A) the reflecting surface (11) of the body (15) is shaped in a stack of layers (16) formed on a first, preferably semiconductor, substrate (70), according to the description of previous embodiments. This stack of layers (16) can e.g. be formed by epitaxial deposition. One can define e.g. a GaAs/AlGaAs/InGaAs stack (16) on a GaAs substrate. Then (Fig. 6B) the top contact (40) is defined and the mirror layers (42, 41) are deposited. The contact (51) can then be made. The obtained structure can subsequently (Fig. 6c) be fixed, e.g. glued, to a second substrate (71). Further requirements to this second substrate (71) can be imposed with respect to heat transfer from the LED, expansion coefficient adapted to the LED, etc. by selection of materials. Possible substrates are sapphire, silicon, and glass. The first substrate (70) can be removed by ways known in the art, including etching, grinding, jet etching, and using an etch-stop layer. The out-coupling interface (13) is now exposed to air (22) (Fig. 6D). When necessary, additional processing such as deposition of dielectric layer (46), formation of contact (45) and finger (53) can then be executed.

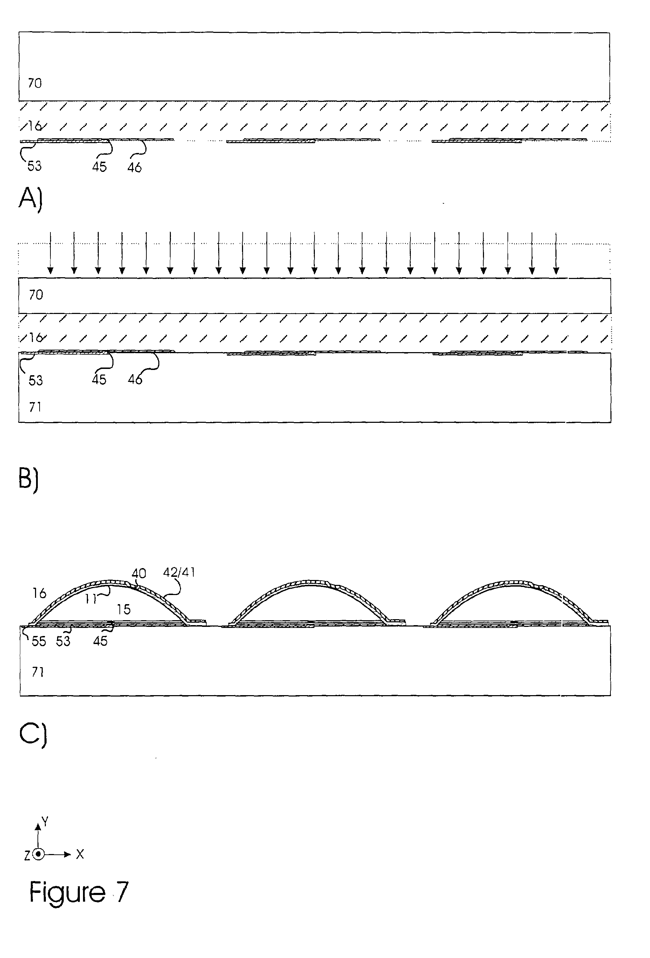

In a second process sequence (Fig. 7) the process sequence of Fig. 6 is interchanged. Firstly, if necessary, dielectric layer (46), contact (45) and finger (53) are constructed on a first substrate (70) comprising the required stack of epitaxial layers (16) (Fig. 7A). Then this first substrate (70) is fixed, e.g. glued, on a second transparent substrate (71) and substrate (70) is removed (Fig. 7b). Subsequently, the reflecting area (11) is formed in the stack of epitaxial layers (16), contacts (40) are made and the mirror (41,42) is formed (Fig. 7C). Now, the light output is at the transparent substrate (71) side.

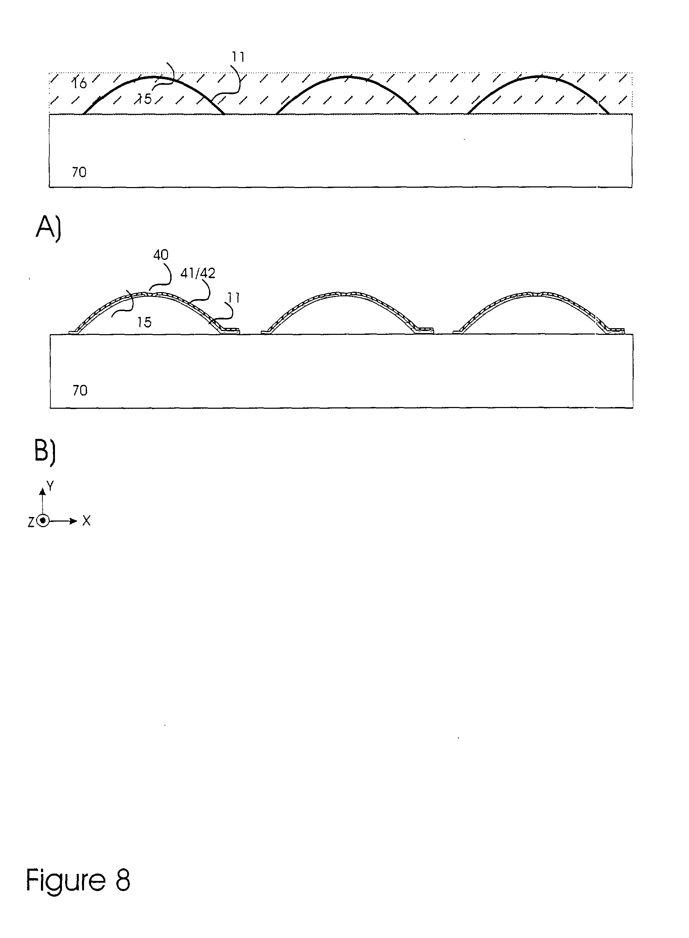

In a third process sequence (see Fig. 8), somewhat less efficient, the initial substrate (70), on which the stack of semiconductor and dielectric layers is formed, itself is transparent for the generated light. No transfer of the stack of layers (16) or of the body (15) is required. The reflecting surface (11) is formed and processing can continue as in the previous, first process sequence (Fig. 6A,B). This third process sequence yields a device with a good output coupling of the photons having an initial upward direction. A reduced number of the photons with a downward direction will couple out finally.

Some applications require more light than an LED according to the present invention could emit in a reliable way. As understood by a person skilled in the art, one- or two-dimensional arrays of LED's according to the present invention can be processed in parallel, thereby applying processing techniques explained in other embodiments. Such arrays of highly efficient parallel beam LED's offer a multiplied output power compared to a single LED. When the LED's of such an array can be addressed separately, e.g. by integrating in or adding to the array an interconnect matrix, such an array can be used for multiple channel optical communication. These parallel processed LED's can be useful for multi-channel optical communication and for high power LED lamps.

## Claims

**1.** A light emitting device, comprising
a body of semiconductor material (15) having a radiation generating zone (10),
said body(15) having at least one reflecting surface(11) and at least one radiating surface (13),
**characterized in that**,
said reflecting surface (11) is oriented to said radiating surface (13) such that radiation emitted by said radiation generating zone (10) is redirected by said reflecting surface (11) to pass through said radiating surface (13) substantially perpendicular to said radiating surface (13).

**2.** A device as recited in claim 1, wherein said radiating surface (13) is substantially planar and said reflecting surface (11) is spherically shaped or shaped as a conic of revolution.

**3.** A device as recited in claim 2, wherein said radiating surface (13) is substantially planar and said reflecting surface (11) is shaped as a paraboloid of revolution.

**4.** A device as recited in claim 2 or 3, wherein said radiating surface (13) is substantially planar and said reflecting surface (11) is shaped as a Fresnel-equivalent of reflecting surface with a spherical or conic of revolution form.

**5.** A device as recited in any of the claims 1 to 4, wherein said radiation generating zone (10) is positioned substantially at the focal point of said reflecting surface (11).

**6.** A device as recited in claim 5, wherein said focal point of said reflecting surface (11) is located adjacent to said radiating surface (13).

**7.** A device as recited in claim 1 wherein said radiating surface (13) has a semi-spherical form or the form of a conic of revolution and said reflecting surface (11) is substantially planar.

**8.** A device as recited in any of the claims 1 to 7 wherein said body of semiconductor material (15) is made of a single semiconductor material.

**9.** A device is recited in any of the claims 1 to 7 wherein said body of semiconductor material (15) is made of at least two semiconductor materials having substantially similar optical refractive indexes.

**10.** A device as recited in any of the claims 1 to 9, wherein said reflecting surface (11) comprises a conductive layer (42) and a dielectric layer (41).

**11.** A device as recited in claim 10, wherein; said dielectric layer (41) comprises silicon dioxide.

**12.** A device as recited in claim 10 or 11, wherein; said conductive layer (42) comprises metal.

**13.** A device as recited in any of the claims 1 to 12, wherein said out-coupling surface (13) is covered with an anti-reflecting layer (46).

**14.** A device as recited in claim 13 wherein said anti-reflecting layer (46) is silicon dioxide.

**15.** A device as recited in any of claims 2 to 14, wherein; said radiation generating zone (10) is confined in directions perpendicular and parallel to said radiating surface (13) by current-confinement techniques.

**16.** A method of manufacturing a light emitting device, comprising a body of semiconductor material (15) having a radiation generating zone (10), a radiating surface (13) and a reflecting surface (11), comprising the steps of:
shaping the surface of said body (15) in a reflecting (11) and a radiating portion (13), said reflecting portion (11) being oriented to said radiating portion (13) such that radiation emitted by said radiation generating zone (10) is redirected at first incidence on said reflecting portion (11) to pass through said radiating portion (13), substantially perpendicular to said radiating portion (13).

**15.** An array comprising one or more devices as recited in any of claims 1 to 15.

**16.** Use of an array as recited in claim 15 for multiple channel optical communication.
